Europäisches Patentamt

European Patent Office

Office européen des brevets

(19)

(11) Numéro de publication : **0 078 726**
**B1**

(12) **FASCICULE DE BREVET EUROPÉEN**

(45) Date de publication du fascicule du brevet :
28.08.85

(51) Int. Cl.⁴ : **H 01 L 47/02**

(21) Numéro de dépôt : **82401919.4**

(22) Date de dépôt : **19.10.82**

(54) Dispositif à transfert d'électrons fonctionnant dans le domaine des hyperfréquences.

(30) Priorité : 30.10.81 FR 8120444

(43) Date de publication de la demande :
11.05.83 Bulletin 83/19

(45) Mention de la délivrance du brevet :
28.08.85 Bulletin 85/35

(84) Etats contractants désignés :
DE GB IT NL

(56) Documents cités :
FR-A- 2 031 421
FR-A- 2 293 068
GB-A- 1 266 154

(73) Titulaire : THOMSON-CSF
173, Boulevard Haussmann
F-75379 Paris Cedex 08 (FR)

(72) Inventeur : Diamand, Félix
THOMSON-CSF SCPI 173, bld Haussmann
F-75379 Paris Cedex 08 (FR)
Inventeur : Etienne, Patrick
THOMSON-CSF SCPI 173, bld Haussmann
F-75379 Paris Cedex 08 (FR)
Inventeur : Nuyen, Trong Linh
THOMSON-CSF SCPI 173, bld Haussmann
F-75379 Paris Cedex 08 (FR)

(74) Mandataire : Taboureau, James et al
THOMSON-CSF SCPI 173, Bld Haussmann
F-75379 Paris Cedex 08 (FR)

Jouve, 18, rue St-Denis, 75001 Paris, France

## Description

L'invention concerne une diode à transfert d'électrons, et plus exactement une nouvelle structure de cathode pour ce type de diode, appelée plus couramment diode Gunn. L'objet de cette nouvelle cathode est d'augmenter la puissance utile de la diode, dans le domaine des hyperfréquences.

Les diodes Gunn sont des composants hyperfréquences de génération ou d'amplification dont le fonctionnement repose sur un mécanisme de résistance négative de volume, inhérent à certains composés de la famille III-V, en particulier GaAs et InP, entre autres.

Selon l'essentiel de ce mécanisme de résistance négative, la bande de conduction des composés III-V tels que le GaAs ou l'InP comporte deux vallées, parfois trois, mais on se limitera au modèle plus simple de deux vallées : la vallée principale dans laquelle les électrons sont très mobiles ($\mu > 5\,000$ cm²/V/s pour une concentration de dopage $N_d \simeq 10^{15}$ cm$^{-3}$) et la vallée secondaire dans laquelle la mobilité est environ 20 fois plus faible. Le minimum secondaire est situé, dans l'échelle des énergies, à quelques dixièmes d'électrons-volts (0,35 ev pour le GaAs, 0,5 eV pour l'InP) au-dessus du minimum principal. Il en résulte que si l'on applique un champ électrique à un barreau de GaAs muni de deux contacts ohmiques, la mobilité apparente sera fonction de la valeur de ce champ électrique. Pour un champ faible, les électrons sont presque tous dans la vallée principale et la mobilité moyenne est grande. Si l'on augmente le champ, l'énergie cinétique moyenne des électrons augmente, donc la population de la vallée secondaire augmente au détriment de la vallée principale, d'où une diminution de la mobilité moyenne. Lorsque le champ atteint une valeur critique $E_c$ de l'ordre de 3 500 V/cm (10 000 V/cm pour l'InP), ce transfert entre vallées devient suffisamment notable pour que la mobilité différentielle soit négative ($\mu_d = dV/dE < 0$). Dans ces conditions, il est possible, si les paramètres physiques sont choisis convenablement (dopage, longueur, etc...) d'obtenir aux bornes du barreau une résistance négative dans un domaine de fréquence plus ou moins étendu englobant la fréquence de transit. C'est ce mécanisme qui est mis en œuvre dans les diodes à transfert d'électrons.

Il est remarquable qu'il s'agit d'un effet de volume, c'est-à-dire associé à un certain type de matériau de composition homogène, par opposition à d'autres effets de résistance négative — diode Tunnel, diode à avalanche — qui sont associés à des structures composites beaucoup plus élaborées. Cependant, malgré la grande simplicité de la structure, l'effet Gunn est un mécanisme très complexe. D'autre part, même pour un matériau parfaitement homogène, la densité statique des électrons n'est pas uniforme dans la direction du champ électrique, l'allure particulière de ce profil de densité étant fonction des conditions aux limites à la cathode et de la valeur du champ appliqué. D'autre part, si le champ est supérieur au champ critique $E_c$ une inhomogénéité de charge électronique tend à croître dans le temps. $\sigma_d$ étant la conductivité différentielle, $\varepsilon$ la constante diélectrique du milieu, le taux de croissance $|\sigma_d|/\varepsilon$ est lié à la relaxation diélectrique, qui correspond à un amortissement négatif puisque $\sigma_d < 0$, tout en se propageant de la cathode vers l'anode à la vitesse moyenne des porteurs. Il s'agit donc d'une instabilité convective dont les caractéristiques dépendent non seulement des propriétés physiques du matériau, mais aussi, d'une manière très critique, des conditions initiales, c'est-à-dire des conditions d'injection à la cathode.

On a proposé jusqu'à présent deux structures de cathode pour réaliser un contact qui contrôle les conditions d'injection. La première solution, connue en particulier de la demande de brevet FR-A-2 031 421, paraît simple, puisqu'il s'agit d'un contact Schottky, mais en fait, pour que ce contact Schottky limite convenablement le courant, il est nécessaire que ce soit un contact à faible barrière, sur matériau N$^+$, et la reproductibilité de tels contacts est mauvaise. La seconde solution consiste à intercaler dans la couche active de la diode une mince couche de dopage élevé, qui permet d'accentuer la valeur du champ électrique dans la région cathodique par rapport au champ dans la région de transit, favorisant ainsi l'injection d'électrons chauds. Il s'agit là d'une structure assez élaborée, puisque la couche active de la diode est composée de trois régions, et la réalisation en est plus difficile et moins reproductible qu'une structure simple.

La solution apportée par la cathode selon l'invention est au contraire à la fois simple de réalisation, et efficace dans ses effets. Elle constitue une modification d'une diode Gunn classique, comportant sur un substrat N$^+$ monocristallin recouvert d'une couche tampon N$^+$ épitaxiée destinée à lisser la surface du substrat, une couche active N et une couche N$^+$ destinée à favoriser la formation d'un contact ohmique métallique de cathode. Le contact d'anode est pris par une métallisation sur le substrat. Selon l'invention, le rapport de transparence de la cathode est modifié par amorphisation d'une partie de la couche N$^+$, sur toute son épaisseur avec un léger empiètement sur la couche N sous-jacente. Le rapport de transparence est modifié en fonction du rapport de la surface cristalline à la surface totale, et la partie amorphisée se présente sous forme de bandes ou de plots disposés selon une grille, obtenus par bombardement de protons.

De façon plus précise, l'invention consiste en un dispositif à transfert d'électrons constituant une diode, fonctionnant dans le domaine des hyperfréquences, dont le corps semiconducteur comprend, déposées sur un substrat monocristallin recouvert d'une couche tampon épitaxiée, une première couche active et une deuxième couche déposée sur la couche active, ainsi que deux métallisations, la première pour le contact anodique sur le substrat et la seconde pour le contact cathodique sur la deuxième couche, ce dispositif étant caractérisé en ce que le corps est en matériau semiconducteur du groupe III-V, le substrat, la couche tampon et la deuxième couche étant dopés N⁺, et la première couche active étant dopée N, et en ce que, en vue de limiter le courant et de renforcer le champ électrique dans la région du contact cathodique, sous la métallisation de cathode sont réalisées dans la deuxième couche des zones isolantes amorphisées, afin de modifier le rapport de transparence de la cathode, celui-ci étant le rapport entre la surface cristalline conductrice et la surface totale, au niveau de la métallisation de cathode.

L'invention sera mieux comprise par la description qui suit, laquelle s'appuie sur les figures jointes qui représentent :

figure 1 courbe représentant la vitesse des électrons en fonction du champ, dans une diode à transfert d'électrons selon l'art connu ;

figure 2 les caractéristiques d'un contact cathodique, selon l'art connu ;

figure 3 profil de concentration, dans une diode à plusieurs zones, selon l'art connu ;

figure 4 mécanisme de fonctionnement de la cathode selon l'invention ;

figure 5 vue en coupe d'une diode à transfert d'électrons, munie d'une cathode selon l'invention ;

figure 6 caractéristiques du contact cathodique selon l'invention ;

figure 7 caractéristiques du contact cathodique selon l'invention, pour différents rapports de transparence.

L'exposé de l'invention sera plus facilement compris par le rappel préliminaire des conditions d'injection des électrons dans les diodes Gunn.

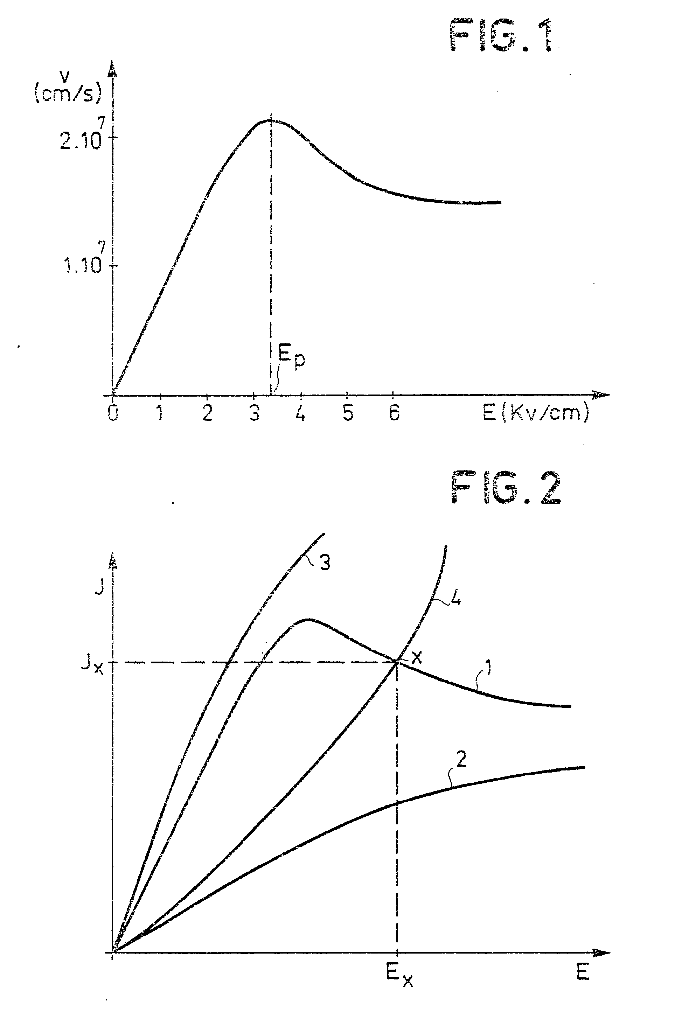

La figure 1 donne la courbe de la vitesse des électrons en fonction du champ électrique, conformément à ce qui a été exposé précédemment, pour une diode en GaAs dopé à $N_d = 10^{15}$ e/cm³ et munie de contacts ohmiques. Le champ étant exprimé en kilovolts par centimètre, on voit sur cette courbe que la vitesse des électrons, en centimètres par seconde, passe par un maximum situé vers 3 500 V/cm pour GaAs. Pour des valeurs du champ inférieures à ce maximum, les électrons se trouvent dans la vallée principale de la bande de conduction, ils sont très mobiles. Pour des valeurs supérieures, les électrons se trouvent dans la vallée secondaire de la bande de conduction et ils sont moins mobiles. La région de la courbe dans laquelle la vitesse décroît lorsque le champ croît présente une résistance négative en volume : c'est le domaine de fonctionnement des diodes à transfert d'électrons.

La figure 1 est relative à un type de contact ohmique, qui est dit injectant. Il existe d'autres types de contacts cathodiques.

Lorsqu'une diode Gunn est couplée à un circuit pour constituer un oscillateur, plusieurs modes de fonctionnement plus ou moins performants sont possibles suivant la nature du contact cathodique et les paramètres physiques de la diode. Une amélioration très notable de la puissance HF et du rendement d'un oscillateur a été obtenue dans le cas de l'InP par une conception appropriée de la région cathodique.

On connaît deux classes de contacts cathodiques : les contacts injectants et les contacts limitants.

Le contact injectant apporte un excès de densité électronique par rapport à la densité de donneurs. Le contact ohmique ou la jonction N⁺N, en sont des exemples typiques. Leurs propriétés sont les suivantes :

a) La densité électronique $n \gg N_d$ au niveau de la cathode et $n > N_d$ dans toute la couche, $N_d$ étant la concentration de dopage. Il y a environ mille fois plus d'électrons, à proximité de la cathode que dans la couche active de la diode.

b) Il en résulte que le champ $E \sim 0$ à la cathode et croît dans toute la couche pour différentes valeurs du courant. La croissance de E(x), c'est-à-dire le champ au point d'abscisse x à partir de la cathode, est modérée si le champ moyen appliqué $E = V/l$ est inférieur au champ critique $E_c$ ; elle devient forte pour $E = > E_c$ en particulier au voisinage de l'anode. Ce profil de champ est défavorable parce qu'il implique l'existence au voisinage de la cathode d'une zone « morte » :

— il existe devant la cathode une région de longueur non négligeable dans laquelle $E \leqslant E_c$. Cette région est donc dissipative. Le poids de ces pertes à haute fréquence est d'autant plus lourd que la longueur totale de la couche active est plus petite, c'est-à-dire que la fréquence est plus élevée. A 100 GHz, la longueur de cette région dissipative est comparable à la longueur de la région utile ;

— de plus, le champ moyen dans la région cathodique étant faible par rapport au champ critique $E_c$, les électrons abordent la région utile où $E \leqslant E_c$ avec une énergie trop faible pour que le transfert dans la vallée secondaire puisse être considéré comme instantané par rapport au temps de transit, ce qui allonge encore l'étendue de la zone morte ;

— le champ dans la région anodique peut atteindre le seuil d'ionisation d'où un risque de destruction de la diode. Même si ce seuil n'est pas atteint, la forte valeur du champ se traduit par un surcroît inutile de puissance appliquée.

c) Les conditions aux limites associées au champ électrique à un contact ohmique conduisent à des instabilités caractérisées par la propagation et la croissance de couches d'accumulation. Le profil de champ associé à ce mode d'oscillation est défavorable : par rapport à la couche d'accumulation, le champ est plus grand du côté aval — donc du côté anode — que du côté amont, et cet écart s'accentue au fur et à mesure que la couche d'accumulation progresse vers l'anode. Ainsi se trouve aggravé le risque de destruction de la diode par claquage au niveau de l'anode.

Le contact limitant conduit à un défaut de densité électronique par rapport à la densité de donneurs. Ses caractéristiques sont les suivantes :

a) La densité électronique $n < N_d$ dans toute la couche. Elle croît de la cathode vers l'anode pour tendre vers $N_d$ si la région de transit est assez longue.

b) Il en résulte que le champ E décroît de la cathode vers l'anode.

c) Un contact limitant peut être bloquant, c'est-à-dire qu'il reste limitant pour toute valeur de champ. Il peut être limitant à bas champ et injectant à haut champ en croisant la caractéristique neutre. Au point de croisement, le champ devient constant dans toute la couche.

d) Un contact limitant évite la formation de couches d'accumulation avec les inconvénients mentionnés précédemment.

e) Le champ étant maximum à la cathode, la zone morte est très étroite, ce qui a permis d'obtenir d'excellentes performances de puissance et rendement dans le cas d'oscillateurs Gunn en InP.

La figure 2 représente les caractéristiques d'un contact cathodique, et donne les différentes courbes de densité de courant J en fonction du champ E, pour les contacts injectants, et les contacts limitants.

Le champ E étant donné en abscisses, et la densité $J = N_d q v(E)$ en ordonnées, la courbe repérée 1 correspond à une caractéristique neutre. La courbe 2, telle qu'elle ne recoupe pas la courbe 1 de caractéristique neutre pour toute valeur du champ, et lui est inférieure, conduit à un contact limitant bloquant. Au contraire, la courbe 3 est d'ordonnée toujours supérieure à la courbe 1 ; quel que soit le champ : elle correspond à un contact injectant. Enfin, la courbe 4 recoupe la courbe 1 en un point X correspondant à un champ $E_x$ : si le champ $E > E_x$, le contact est injectant et si $E < E_x$ le contact est limitant.

On a proposé jusqu'à présent deux conceptions technologiques pour réaliser un contact limitant.

Le contact Schottky utilise une barrière très faible de 0,15 à 0,25 eV. L'inconvénient de ce contact est que si l'injection se fait par émission thermo-ionique, elle est très sensible à la température, ce qui est gênant pour des composants utilisés dans des équipements militaires et spatiaux. On peut remédier à cette situation en utilisant un contact Schottky sur matériau $N^+$, ce qui donne une injection tunnel peu sensible à la température, mais risque par contre de conduire à une limitation insuffisante du courant. En outre, la reproductibilité des contacts Schottky de faible barrière est médiocre.

La cathode à une ou deux zones : il s'agit d'un contact ohmique ou Schottky faible barrière, sur une région dopée $N^-$, suivie par une seconde région, peu épaisse mais très dopée.

La première région conduit à une limitation de courant, le pic de dopage de la seconde région permet d'accentuer la valeur du champ dans la région cathodique par rapport au champ dans la région de transit, favorisant ainsi l'injection d'électrons chauds. Ce type de cathode a été expérimenté sur InP, où la zone morte est plus étendue que dans le cas du GaAs. Il permet des conditions de fonctionnement beaucoup moins sensibles à la température que le contact Schottky tout en offrant une limitation en courant. Cependant, il s'agit d'une structure très élaborée dont la réalisation est difficile et probablement peu reproductible.

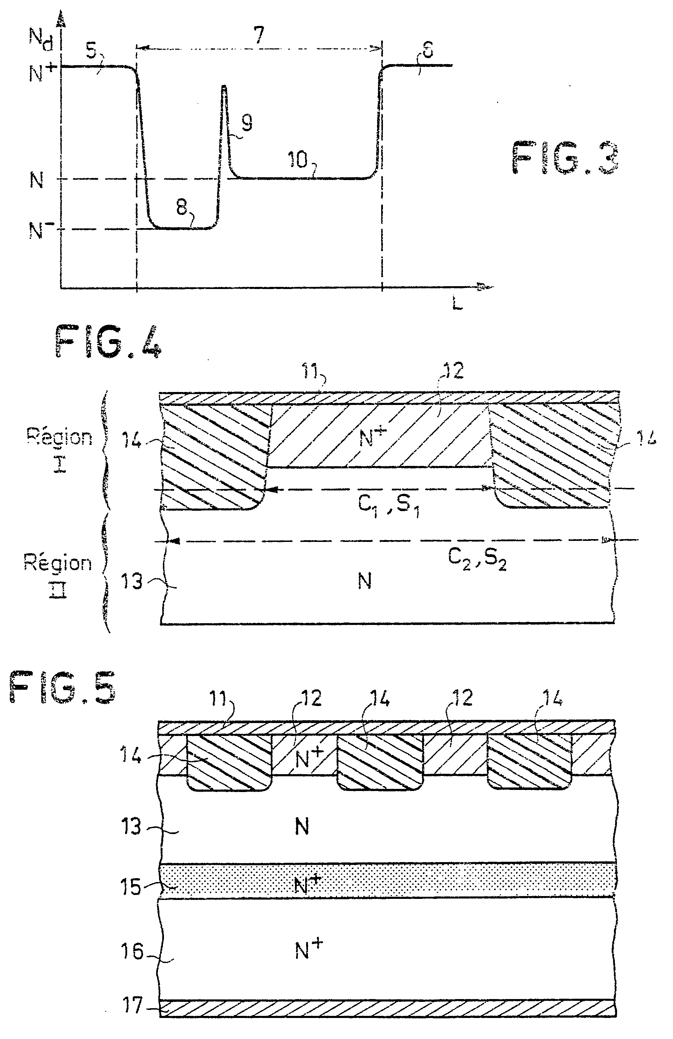

La figure 3 représente le profil de concentration d'une telle diode connue, à plusieurs zones.

La concentration de dopage $N_d$ étant portée en ordonnées, les abscisses représentent des distances : on a ainsi une coupe d'une diode, la cathode étant la région 5, l'anode la région 6 et les différentes couches de la diode dans la partie centrale 7. Dans celle-ci, la région 8 est celle qui, dopée $N^-$, conduit à une limitation de courant, et la région 9, par son pic de dopage, accentue le champ dans la région 8, supprime le fonctionnement dissipatif, et injecte des électrons chauds dans la couche active 10 de la diode.

La représentation des niveaux de dopage dans les régions 5 et 6 correspond aux couches $N^+$ situées sous les métallisations de prises de contact, cathode et anode.

La figure 4 représente un fragment de la cathode selon l'invention, et permettra d'expliquer le mécanisme de l'invention. Cette figure 4 est limitée aux deux premières couches de la diode : celles qui ne sont pas nécessaires à la compréhension ne sont pas représentées.

La structure cathodique comprend, à partir de la métallisation 11 de prise de contact, une couche 12 de dopage $N^+$ et une couche 13 de dopage N. Des zones isolantes 14 amorphisées, réalisées par des techniques qui seront décrites ultérieurement, sont délimitées en surface de la cathode, de manière à diminuer la section offerte au courant : on appelle rapport de transparence le rapport de la surface cristalline restante de la couche 12 sur la surface totale du contact cathodique. Sur la figure 4, l'épaisseur des zones isolantes 14 dépasse légèrement celle de la couche $N^+$ 12, qui est de l'ordre de 0,5 µ à 1 µ.

Cependant, appartiennent au domaine de l'invention les cas où l'épaisseur des zones isolantes est égale ou inférieure à l'épaisseur de la couche $N^+$ 12.

On divise ainsi l'espace de la diode en deux régions, la région I dans laquelle la section offerte au courant est $S_1$, et la région II de section $S_2$ plus grande. Soient $C_1$ et $C_2$ deux plans proches et situés de part et d'autre du plan de séparation des régions I et II : ils ont donc des sections $S_1$ et $S_2$ respectivement. Cette structure possède des caractéristiques d'injection comparables à celles de la cathode à deux zones. Soient $E_1$, $I_1$ et $E_2$, $I_2$ les champs et les courants dans les plans $C_1$ et $C_2$. La continuité de courant impose :

$$I_1 = I_2$$

D'autre part, si les plans $C_1$ et $C_2$ sont suffisam-

ment rapprochés, le théorème de Gauss donne :

$$E_1 S_1 \simeq E_2 S_2$$

En effet, le plan $C_1$ étant placé légèrement au-delà de la couche $N^+$ et le contact $N^+$ étant injectant, on a en $C_1 : n > N_d$. D'autre part, le rapport des sections $S_2/S_1$ est choisi suffisamment grand pour qu'au niveau du plan $C_2$ il y ait limitation de courant, donc $n < N_d$. On peut donc choisir $C_1$ et $C_2$ de telle sorte que la charge totale contenue dans le volume ainsi délimité soit nulle. Bien entendu ce mécanisme n'est valable que pour un courant donné, mais une diode Gunn fonctionne avec un courant de polarisation pratiquement fixe.

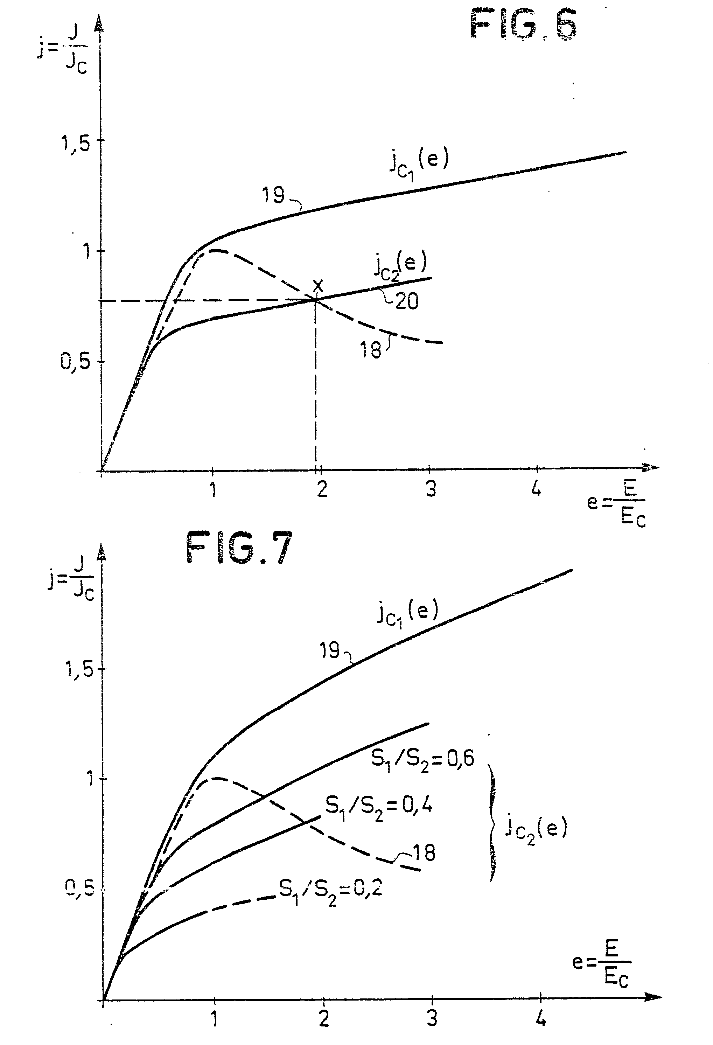

La figure 5 représente une vue en coupe d'une diode à transfert d'électrons munie d'une cathode selon l'invention.

La structure de base est classique : sur un substrat 16, monocristallin, $N^+$, en GaAs ou InP ou tout autre matériau de même genre, du groupe III-V, est déposée une couche tampon 15, épitaxiée, de type $N^+$ et du même matériau que le substrat 16. La fonction de la couche tampon 15 est d'atténuer les défauts de surface du substrat, tels que rayures de polissage. Puis une couche active 13, de type N, est épitaxiée sur la couche tampon 15, et enfin une couche superficielle 12, de type $N^+$, ces deux dernières couches étant elles aussi en GaAs ou InP. Deux métallisations de prise de contact complètent la diode, une métallisation 17 sur le substrat pour l'anode, et une métallisation 11 pour la cathode.

Suivant un mode de réalisation de la diode selon l'invention, avant de déposer la métallisation 11 de cathode, une partie de la couche superficielle 12 et la partie de la couche active 13 située en regard sont amorphisées de telle façon que les zones isolantes amorphisées 14 ainsi formées pénètrent dans la couche active 13. Les zones amorphisées 14 peuvent être de géométries telles que des bandes, parallèles ou non, des anneaux, concentriques ou non, ou des plots disposés en grille ou en damier : l'important est de modifier le rapport de transparence de la cathode, afin de limiter le courant dans cette région cathodique, et de renforcer le champ pour produire des électrons chauds. A titre purement indicatif, pour une largeur de maille de 2,5 μ de la grille amorphisée, une bande ou plot 14 a une largeur de 0,7 μ.

Les zones isolantes 14 peuvent être réalisées par différentes techniques dont l'implantation ionique ou la croissance épitaxiale par jets moléculaires sur des surfaces amorphes.

La technique d'implantation ionique consiste à amorphiser le matériau semiconducteur, par implantation de protons ou d'ions tels que $H^+$, $O^+$, etc... sous 80 keV et $4,10^{14}$ coulombs/cm². La délimitation des zones implantées se fait par photolithographie.

Pour délimiter les zones isolantes 14 par épitaxie par jets moléculaires, on réalise d'abord la structure substrat $N^+$ — tampon $N^+$ — couche active N. Puis on dépose sur les parties appropriées une couche mince de matériau amorphe tel que $SiO_2$, ou on oxyde légèrement la surface du semiconducteur. On dépose ensuite par épitaxie par jets moléculaires les couches $N^+$ 13 et $N^+$ 12 nécessaires à la constitution complète de la structure de la diode. Sur les parties où existe le matériau amorphe, le dépôt est irrégulier et isolant, tandis qu'ailleurs les couches ont les propriétés N ou $N^+$ désirées.

La figure 6 donne un exemple des caractéristiques d'une diode selon l'invention, pour un rapport des sections $S_1/S_2 = 0,6$, les autres variables de la diode étant $N_d = 2,10^{15}$ e/cm³, la longueur critique $\lambda = \varepsilon\, E_C/qN_d = 0,1\ \mu$ et $\Delta\iota = 0,6\ \mu$ la distance entre les deux plans de mesure $C_1$ et $C_2$. En abscisse est donné le champ normalisé $e = E/E_C$ et en ordonnée la densité normalisée $j = J/J_C$.

La courbe 18 représente la caractéristique neutre, la courbe 19 la caractéristique cathodique $j_{C1}(e)$ et la courbe 20 la caractéristique cathodique $J_{C2}(e)$.

On voit qu'il y a limitation de courant pour des champs inférieurs à environ $2E_C$ et injection au-delà. Cette structure offre donc les possibilités suivantes :
— fonctionnement en limitation de courant pour $E < 2E_C$ ou à l'intersection de la caractéristique neutre ;
— injection d'électrons chauds dans la région utile puisque $E_1 = E_2/0,6$.

Si l'on diminue le rapport $S_1/S_2$, l'énergie des électrons injectés augmente, mais le point d'intersection avec la caractéristique neutre se déplace vers les champs élevés dans lesquels la mobilité différentielle devient faible, d'où la nécessité d'un compromis.

La figure 7 montre l'influence du rapport $S_1/S_2$, pour une géométrie légèrement différente puisque $\Delta\iota = 0,3\ \mu$. On voit qu'un rapport $S_1/S_2$ de l'ordre de 0,5 constitue un ordre de grandeur raisonnable. Pour $S_1 S_2 = 0,2$, le contact est pratiquement bloquant. La valeur optimum de $S_1/S_2$ doit être ajustée dans chaque cas. Ce résultat peut être obtenu empiriquement au niveau de la réalisation des zones isolantes par les techniques de masquage, un même masque pouvant comporter plusieurs motifs. C'est là un avantage de cette structure sur la cathode composite à une ou deux zones dont la réalisation relève de l'épitaxie.

**Revendications**

1. Dispositif à transfert d'électrons constituant une diode, fonctionnant dans le domaine des hyperfréquences, dont le corps semiconducteur comprend, déposées sur un substrat monocristallin (16) recouvert d'une couche tampon épitaxiée (15), une première couche active (13) et une deuxième couche (12) déposée sur la couche active (13), ainsi que deux métallisations, la première (17) pour le contact anodique sur le substrat (16) et la seconde (11) pour le contact cathodique sur la deuxième couche (12), ce dispositif étant caractérisé en ce que le corps est en matériau semiconducteur du groupe III-V, le substrat (16), la couche tampon (15) et la deuxième couche (12) étant dopés N⁺, et la première couche active (13) étant dopée N, et en ce que, en vue de limiter le courant et de renforcer le champ électrique dans la région du contact cathodique, sous la métallisation (11) de cathode sont réalisées dans la deuxième couche (12) des zones isolantes amorphisées (14), afin de modifier le rapport de transparence de la cathode, celui-ci étant le rapport entre la surface cristalline conductrice et la surface totale, au niveau de la métallisation (11) de cathode.

2. Dispositif selon la revendication 1, caractérisé en ce que les zones isolantes amorphisées (14) ont une épaisseur inférieure à celle de la deuxième couche (12) dans laquelle elles sont réalisées.

3. Dispositif selon la revendication 1, caractérisé en ce que les zones isolantes amorphisées (14) ont une épaisseur égale à celle de la deuxième couche (12) dans laquelle elles sont réalisées, de sorte qu'elles sont en contact avec la première couche active (13).

4. Dispositif selon la revendication 1, caractérisé en ce que les zones isolantes amorphisées (14) ont une épaisseur supérieure à celle de la deuxième couche (12) dans laquelle elles sont réalisées, de sorte qu'une partie de la première couche active (13) est également rendue isolante.

5. Dispositif selon la revendication 1, caractérisé en ce que les zones isolantes (14) sont réalisées sous forme de bandes.

6. Dispositif selon la revendication 1, caractérisé en ce que les zones isolantes (14) sont réalisées sous forme d'anneaux.

7. Dispositif selon la revendication 1, caractérisé en ce que les zones isolantes (14) sont réalisées sous forme de plots disposés en grille.

8. Dispositif selon la revendication 1, caractérisé en ce que le mode de fonctionnement de la région cathodique, en limitation de courant ou en injection d'électrons chauds vers l'anode, est réglé par le rapport entre la surface cristalline de la deuxième couche (12) et la surface des zones isolantes (14), le rapport surface cristalline sur surface totale de la cathode étant compris entre 0,2 et 0,6.

9. Dispositif selon la revendication 1, caractérisé en ce que, les première (13) et deuxième (12) couches de la région cathodique étant épitaxiées, les zones isolantes (14) y sont créées par implantation ionique, telle que bombardement de protons.

10. Dispositif selon la revendication 1, caractérisé en ce que la première couche (13) étant épitaxiée, les zones isolantes (14) sont réalisées par dépôt, localisé sur la première couche (13) et à l'endroit desdites zones isolantes (14), d'un matériau amorphe en couche mince, puis épitaxie en jet moléculaire : la couche épitaxiée est isolante (14) sur le matériau amorphe, et dotée de propriétés N ou N⁺ (12 et 13) en dehors des dépôts de matériau amorphe.

## Claims

1. Electron transfer device forming a diode operating in the microwave range and the semiconductor body of which comprises, deposited on a monocrystalline substrate (16) covered by an epitaxial buffer layer (15), a first active layer (13) and a second layer (12) deposited on the active layer (13) as well as two metallizations, the first (17) for the anodic contact on the subsrate (16) and the second (11) for the cathodic contact on the second layer (12), this device being characterized in that the body is of a semiconductor material of the group III-V, the substrate (16), the buffer layer (15) and the second layer (12) being N⁺-doped, and the first active layer (13) being N-doped, and in that, in order to limit the current and to increase the electric field in the region of cathodic contact, insulating zones (14) rendered amorphous are formed beneath the cathode metallization (11) within the second layer (12) in order to modify the transparency ratio of the cathode, which is defined as the ratio between the conductive crystalline surface and the total surface at the cathode metallization (11).

2. Device according to claim 1, characterized in that the insulating zones (14) rendered amorphous have a thickness inferior to that of the second layer (12) wherein they are formed.

3. Device according to claim 1, characterized in that the insulating zones (14) rendered amorphous have a thickness equal to that of the second layer (12) wherein they are formed, in such a manner that they are contacting the first active layer (13).

4. Device according to claim 1, characterized in that the insulating zones (14) rendered amorphous have a thickness exceeding that of the second layer (12) wherein they are formed, in such a manner that part of the first active layer (13) is likewise made insulating.

5. Device according to claim 1, characterized in that the insulating zones (14) are formed in the shape of stripes.

6. Device according to claim 1, characterized in that the insulating zones (14) are formed as rings.

7. Device according to claim 1, characterized in that the insulating zones (14) are formed as small blocks arranged in the form of a grid.

8. Device according to claim 1, characterized in that the mode of operation of the cathodic region with respect to current limitation or injection of hot electrons towards the anode is adjusted by the ratio between the crystalline surface of the second layer (12) to the surface of the insulating zones (14), the ratio of the crystalline surface to the total surface of the cathode being comprised between 0.2 and 0.6.

9. Device according to claim 1, characterized in that, the first (13) and second (12) layers of the cathodic region being formed by epitaxy, the insulating zones (14) are formed therein by ion implantation such as protonic bombing.

10. Device according to claim 1, characterized in that the first layer (13) being formed by epitaxy, the insulating zones (14) are formed by localized deposition of an amorphous material in the form of a thin layer vertically with respect to said insulating layers (14), with subsequent epitaxy from the molecular jet : the epitaxially formed layer being insulating (14) on the amorphous material and N-doped or $N^+$-doped (12 and 13) outside of the amorphous material deposit.

## Patentansprüche

1. Vorrichtung zur Überführung von Elektronen, welche eine Diode bildet und im Mikrowellengebiet arbeitet, mit einem Halbleiterkörper, welcher auf einem monokristallinen, von einer epitaktischen Pufferschicht (15) bedeckten Substrat (16) abgelagert eine erste aktive Schicht (13) und eine zweite Schicht (12), die auf der aktiven Schicht (13) abgelagert ist, sowie zwei Metallisierungen aufweist, die erste (17) für den Anodenkontakt an dem Substrat (16) und die zweite (11) für den Katodenkontakt an der zweiten Schicht (12), wobei diese Vorrichtung dadurch gekennzeichnet is, daß der Körper aus einem Halbleitermaterial der Gruppe III-V besteht, das Substrat (16), die Pufferschicht (15) und die zweite Schicht (12) $N^+$-dotiert sind, während die erste aktive Schicht (13) N-dotiert ist, und daß zur Strombegrenzung und Verstärkung des elektrischen Feldes in dem Bereich des Katodenkontaktes unter der Katodenmetallisierung (11) in der zweiten Schicht (12) amorph gemachte Isolierzonen (14) gebildet sind, um das Durchlässigkeitsverhältnis der Katode zu verändern, wobei es sich um das Verhältnis zwischen der leitfähigen kristallinen Oberfläche und der Gesamtoberfläche im Bereich der Katodenmetallisierung (11) handelt.

2. Vorrichtung nach Anspruch 1, dadurch gekennzeichnet, daß die amorph gemachten Isolierzonen (14) eine Dicke aufweisen, die kleiner als die der zweiten Schicht (12) ist, worin sie gebildet sind.

3. Vorrichtung nach Anspruch 1, dadurch gekennzeichnet, daß die amorph gemachten Isolierzonen (14) eine Dicke aufweisen, die gleich der der zweiten Schicht (12) ist, worin sie gebildet sind, so daß sie in Kontakt mit der ersten aktiven Schicht (13) sind.

4. Vorrichtung nach Anspruch 1, dadurch gekennzeichnet, daß die amorph gemachten Isolierzonen (14) eine Dicke aufweisen, die größer als die der zweiten Schicht (12) ist, worin sie gebildet sind, so daß ein Teil der ersten aktiven Schicht (13) ebenfalls isolierend gemacht ist.

5. Vorrichtung nach Anspruch 1, dadurch gekennzeichnet, daß die Isolierzonen (14) streifenförmig ausgebildet sind.

6. Vorrichtung nach Anspruch 1, dadurch gekennzeichnet, daß die Isolierzonen (14) ringförmig ausgebildet sind.

7. Vorrichtung nach Anspruch 1, dadurch gekennzeichnet, daß die Isolierzonen (14) in Form von gitterförmig angeordneten Klötzchen ausgebildet sind.

8. Vorrichtung nach Anspruch 1, dadurch gekennzeichnet, daß die Arbeitsweise des Katodengebietes hinsichtlich Strombegrenzung oder Injektion von heißen Elektronen zur Anode eingestellt ist durch das Verhältnis zwischen der kristallinen Oberfläche der zweiten Schicht (12) und der Oberfläche der Isolierzonen (14), wobei das Verhältnis der kristallinen Oberfläche zur gesamten Katodenoberfläche zwischen 0,2 und 0,6 beträgt.

9. Vorrichtung nach Anspruch 1, dadurch gekennzeichnet, daß die erste (13) und die zweite (12) Schicht des Katodengebietes epitaktisch ausgebildet sind und die Isolierzonen (14) darin durch Ionenimplantation wie durch Protonenbeschuß gebildet sind.

10. Vorrichtung nach Anspruch 1, dadurch gekennzeichnet, daß die erste Schicht (13) epitaktisch ist und die Isolierzonen (14) durch auf der ersten Schicht (13) in der Senkrechten der genannten Isolierzonen (14) lokalisierte Ablagerung eines amorphen Materials in From einer Dünnschicht mit anschließender Epitaxie aus dem Molekülstrahl gebildet werden : Die epitaktische Schicht ist auf dem amorphen Material isolierend (14) und außerhalb des amorphen Materials N- oder $N^+$-dotiert (12 und 13).

0 078 726

FIG.1

FIG.2

FIG.3

FIG.4

Région I

Région II

FIG.5

FIG.6

FIG.7

3